# EUROPEAN PATENT SPECIFICATION

(11) **EP 1 933 468 B1**
(45) Date of publication and mention of the grant of the patent: **04.11.2009**
(21) Application number: 06126170.7
(22) Date of filing: 14.12.2006
(51) Int. Cl.: H04B 1/38, H03J 3/04, G01S 1/00, H03L 1/02

(54) **Wireless communications device providing temperature-compensated clock correction features and related methods**
Drahtloses Kommunikationsgerät, das temperaturkompensierte Taktkorrekturmerkmale bereitstellt, und zugehörige Verfahren
Dispositif de communications sans fil disposant de fonctions de correction d'horloge à compensation thermique et procédés associés

(43) Date of publication of application: 18.06.2008
(73) Proprietor: Research In Motion Limited, Waterloo, Ontario N2L 3W8 (CA)
(72) Inventor: Goldsmith, Michael Andrew, Waterloo, Ontario N2L 4W6 (CA)
(74) Representative: Fennell, Gareth Charles

(56) References cited:
- US-A- 5 172 075
- US-A- 5 663 735
- US-A1- 2003 176 204
- US-B1- 6 928 275

## Description

### Field of the Invention

The present invention relates to the field of communications devices, and, more particularly, to mobile wireless communications devices and related methods.

### Background

Cellular communications systems continue to grow in popularity and have become an integral part of both personal and business communications. Cellular telephones allow users to place and receive voice calls most anywhere they travel. Moreover, as cellular telephone technology has increased, so too has the functionality of cellular devices and the different types of devices available to users. For example, many cellular devices now incorporate personal digital assistant (PDA) features such as calendars, address books, task lists, etc. Moreover, such multi-function devices may also allow users to wirelessly send and receive electronic mail (email) messages and access the Internet via a cellular network and/or a wireless local area network (WLAN), for example.

Another function that has also been recently implemented in some cellular devices is satellite positioning capabilities. By way of example, some cellular devices include not only a cellular transceiver, but also a Global Positioning System (GPS) receiver that receives GPS satellite positioning signals and allows the device to determine its present location. This information can then be used with applications running on the device to advantageously provide the user with desired mapping and/or navigational information, all from the convenience of his cell phone.

Generally speaking, in such configurations the cellular transceiver within the device operates based upon a different clock signal than the GPS receiver. Since the cellular transceiver regularly communicates with a cellular network when turned on, the device has access to timing information from the cellular network that can be used to keep the cellular clock within the device very accurately calibrated. As a result, in some implementations the cellular device clock signal is, in turn, used to help calibrate the GPS clock so that it too can maintain a high degree of accuracy. This approach is called frequency aiding.

One exemplary system which implements a frequency aiding technique for a GPS receiver in a cellular phone is set forth in U.S. Patent No. 6,741,842 to Goldberg et al. This patent is directed to a frequency management scheme for a hybrid cellular/GPS or other device that generates a local clock signal for the communications portion of the device using a crystal oscillator. The oscillator output is corrected by way of an automatic frequency control (AFC) circuit or software to drive the frequency of that clock signal to a higher accuracy. Besides being delivered to the cellular or other communications portion of the hybrid device, the compensated clock signal may also be delivered to a comparator to measure the offset between the cellular oscillator and the GPS oscillator. The error in the cellular oscillator may be measured from the AFC operation in the cellular portion of the device. An undershoot or overshoot in the delta between the two oscillators may thus be deduced to be due to bias in the GPS oscillator, whose value may then be determined. That value may then be used to adjust Doppler search, bandwidth or other GPS receiver characteristics to achieve a better Time to First Fix or other performance characteristics.
United States Patent Application No. 6,928,275 discloses the frequency error of an oscillator is minimized by characterizing the oscillator. A reference signal from an external source containing a minimal frequency error is provided to an electronic device. The external signal is used as a reference frequency to estimate the frequency error of an internal frequency source. The electronic device monitors parameters that are determined to have an effect on the frequency accuracy of the internal frequency source. Temperature is one parameter known to have an effect on the frequency of the internal frequency source. The electronic device collects and stores the values of the parameters as well as the corresponding output frequency or frequency error of the internal frequency source. The resultant characterization of the internal frequency source is used to compensate the internal frequency source when the internal frequency source is not provided the external reference signal.
U.S. Patent No. 5,864,315 to Welles, II et al. is a direct sequence spread spectrum signal processing system that permits the receiver to be turned off during most of the acquisition phase of reception to reduce the on time of the associated receiver front end. Power requirements are further reduced by use of low power high accuracy time and frequency circuits in GPS based tracking units. The microprocessor based GPS tracking system is shut down almost all the time, using extremely little electrical power, and is powered up for very short periods of time at scheduled intervals by a low power clock circuit with accuracy that varies with temperature. Each time the microprocessor is powered up, system temperature is recorded in memory. A correction table provides a temperature history based correction to the lower power clock based circuit without reference to the GPS system, and provides a highly accurate time standard.

While such systems may be advantageous for providing more accurate cellular and GPS reference clock signals when timing signals from a cellular network are available, their accuracy may be less than desirable when such timing signals are unavailable. Accordingly, new clock reference configurations may be desirable in such applications.

### Brief Description of the Drawings

FIG. 1 is a schematic block diagram of a wireless communications device including a clock correction circuit for a satellite positioning clock circuit.

FIG. 2 is a schematic block diagram of the clock correction circuitry of the wireless communications device of FIG. 1.

FIG. 3 is a schematic block diagram of an exemplary embodiment of the clock correction circuitry of the wireless communications device of FIG. 1.

FIG. 4 is a flow diagram illustrating a clock correction method for a wireless communications device including a satellite positioning clock circuit in accordance with an exemplary embodiment.

FIG. 5 is a schematic block diagram illustrating additional components that may be included in the mobile wireless communications device of FIG. 1.

### Detailed Description

The present description is made with reference to the accompanying drawings, in which preferred embodiments are shown. However, many different embodiments may be used, and thus the description should not be construed as limited to the embodiments set forth herein. Rather, these embodiments are provided so that this disclosure will be thorough and complete. Like numbers refer to like elements throughout, and prime notation is used to indicated similar elements in different embodiments.

Generally speaking, a wireless communications device is disclosed herein which may include a portable housing, and a temperature-compensated clock circuit carried by the portable housing. The device may further include a wireless receiver carried by the portable housing for receiving timing signals, when available, from a wireless network, and a satellite positioning clock circuit carried by the portable housing. In addition, at least one clock correction circuit may be carried by the portable housing for correcting the temperature-compensated clock circuit based upon timing signals from the wireless network when available, and storing historical correction values for corresponding temperatures. The at least one clock correction circuit may also correct the temperature-compensated clock circuit based upon the stored historical correction values when timing signals are unavailable from the wireless network, and correct the satellite positioning clock based upon the temperature-compensated clock circuit.

More particularly, the wireless receiver may be a cellular receiver, for example. The wireless receiver may also be a satellite positioning receiver in some embodiments. Furthermore, the temperature-compensated clock circuit may include a voltage-controlled temperature-compensated clock circuit, and the historical correction values may include voltage correction values for the voltage-controlled temperature-compensated clock circuit.

Additionally, the wireless communications device may further include a temperature sensor carried by the portable housing and connected to the at least one clock correction circuit. Also, the at least one clock correction circuit may include a processor. The satellite positioning clock circuit may include a temperature-compensated crystal oscillator (TCXO), and the device may also include an analog-to-digital converter coupled between the temperature-compensated clock circuit and the at least one clock correction circuit. Furthermore, the device may also include a digital-to-analog converter (DAC) coupled between the at least one clock correction circuit and the temperature-compensated clock circuit.

A clock correction method for a wireless communications device, such as the one described briefly above may include, when timing signals are available from the wireless network, correcting the temperature-compensated clock circuit based upon the timing signals and storing historical correction values for corresponding temperatures. Moreover, when timing signals are unavailable from the wireless network, the method may further include correcting the temperature-compensated clock circuit based upon the stored historical correction values. In addition, the satellite positioning clock circuit may be corrected based upon the temperature-compensated clock circuit.

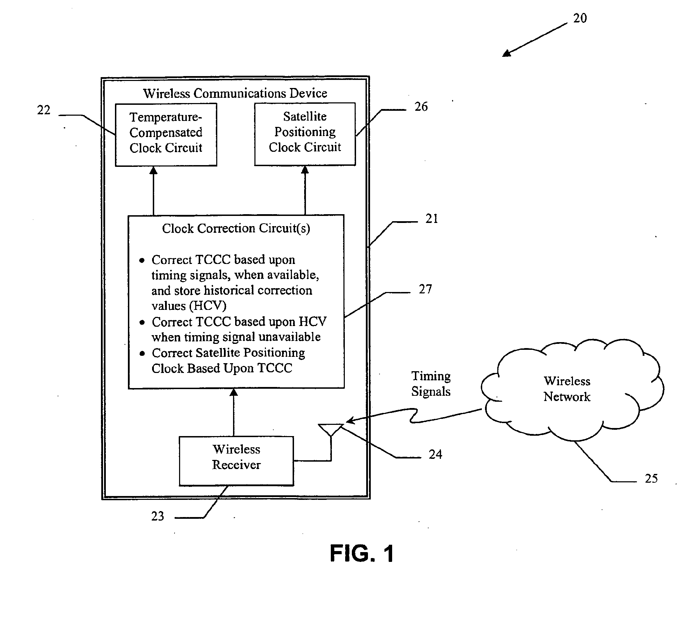

Referring initially to FIG. 1, a wireless communications system **30** illustratively includes a portable housing **21** and a temperature-compensated clock circuit **22** carried by the portable housing. The device **20** may further include a wireless receiver **23** and associated antenna **24** carried by the portable housing **21** for receiving timing signals, when available, from a wireless network **25.** By way of example, the wireless receiver **23** may be a cellular receiver, and the wireless network **25** may be a cellular network. However, in other embodiments, other types of receivers may be used for receiving timing signals from other types of wireless networks, such as a satellite positioning system network, for example, as will be described further below. A wireless local area network (LAN) implementation could be used as well.

The device **20** further illustratively includes a satellite positioning clock circuit **26** carried by the portable housing **21.** In addition, at least one clock correction circuit **27** is illustratively carried by the portable housing **21.** Generally speaking, the clock correction circuitry **27** is for correcting the temperature-compensated clock circuit **22** based upon timing signals from the wireless network **25,** when available, and also storing historical correction values for corresponding temperatures during this time (i.e., while the timing signals are available). Yet, when timing signals are unavailable from the wireless network **25,** the clock correction circuitry **27** advantageously corrects the temperature-compensated clock circuit based upon the stored historical correction values, and corrects the satellite positioning clock accordingly.

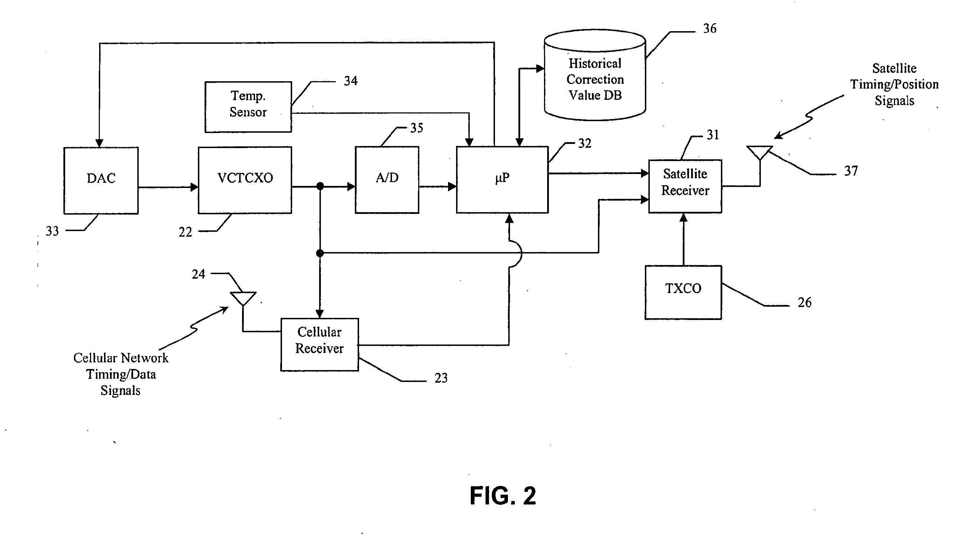

Referring now more particularly to FIG. 2, the various components and operation of the clock correction circuitry **27** are further described. As illustrated, the wireless communications device **20** is a cellular device and the receiver **23** is a cellular receiver (which may be part of a cellular transceiver, for example). The device **20** also illustratively includes a satellite positioning receiver **31** and associated antenna **37** for receiving satellite positioning signals, such as Global Positioning System (GPS) signals. However, it will be appreciated by those skilled in the art that other satellite positioning systems, such as GLONASS, Galileo, EGNOS, Beidou, etc., may also be used. Accordingly, a user is provided with cellular service as well as satellite navigation capabilities all from a single wireless communications device.

In the present example, the temperature-compensated clock circuit **22** is a voltage-controlled temperature-compensated clock circuit, such as a voltage-controlled temperature-compensated crystal oscillator (VCTCXO), and the satellite positioning clock circuit **26** is a temperature-compensated crystal oscillator (TCXO). Moreover, a microprocessor **32** connected to the cellular receiver **23** for controlling the VCTCXO **22** based upon the timing signals received from the cellular network. More particularly, digital control signals from the microprocessor **32** are converted to analog control signals for the VCTCXO **22** by a digital-to-analog converter (DAC) **33.**

As discussed briefly above, cellular networks provide very accurate timing information that can be used by the processing circuitry of a cellular device to enhance the accuracy of the satellite clock signal used by the satellite receiver **31.** This process is generally referred to as frequency aiding, and further information on this approach may be found in the above-noted U.S. Patent No. 6,741,842.

Yet, there are circumstances when cellular network timing signals are unavailable to the device **20,** such as when the device is out of a coverage area, there is a network outage, or the user has turned off the cellular receiver **23,** for example. Moreover, GPS receiver circuitry, for example, requires a very accurate clock reference in order to perform correlation. The more accurate the clock, the faster the Time To First Fix (TTFF). Network aiding data (A-GPS) is usually provided to the GPS unit to narrow the search window in order to improve TTFF, but when no aiding data or cellular network timing signals are available then an autonomous TTFF may be very long.

To provide faster TTFFs in such conditions, the device **20** also advantageously includes a temperature sensor **34,** preferably positioned adjacent the VCTCXO **22,** and providing an input to the microprocessor **32.** Furthermore, an analog-to-digital (A/D) converter samples the analog frequency output of the VCTCXO **22** to provide a digital input to the microprocessor **32.** An A/D converter (not shown) may also be connected between the temperature sensor **34** and the microprocessor **32.** When the device **20** has network timing information (either from a cellular base station or from GPS satellites, depending upon the given implementation), the microprocessor **32** self-calibrates the VCTCXO and builds a logical table of VCTCXO performance to temperature based upon the temperature data provided by the temperature sensor **34** and the corresponding voltage control level output to the DAC **33.** That is, the values stored in the table provide an indication as to how far the VCTCXO **22** has drifted from its center frequency based on historical measurements.

The historical correction data may be stored in a memory **36,** which in FIG. 2 is illustratively shown as a database module. In this way, the microprocessor **32** utilizes a deterministic approach to control the VCTCXO **22** based upon on temperature when no network timing signals are available, and can therefore provide a more accurate reference for the satellite receiver **31** and improve TTFF.

The offset correction for the VCTCXO **22** may be used in different ways to improve the accuracy of the TXCO **26** clock signal for the satellite receiver **31.** In the illustrated example, the microprocessor **22** provides an offset correction output directly to the GPS receiver **31,** which includes the requisite internal processing circuitry to compensate the TXCO **26** clock signal based upon the offset correction from the microprocessor **32** and the output of the VCTCXO **22.**

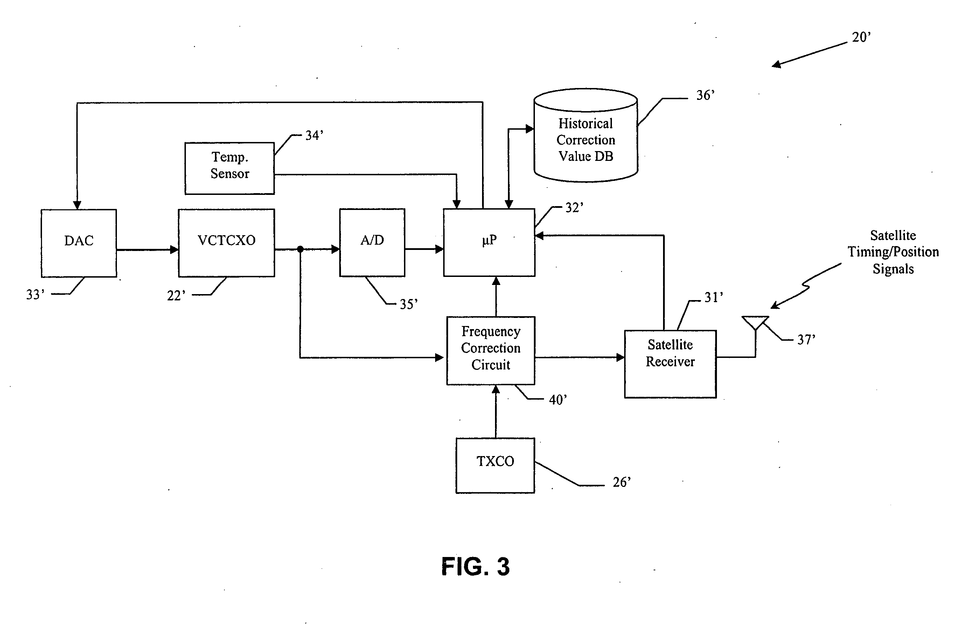

In an embodiment now described with reference to FIG. 3, the outputs of the VCTCXO **22** and TXCO **26** may be input to a frequency correction circuit **40'** along with the offset correction output from the microprocessor **32',** which in turn can provide the satellite reference clock signal to the satellite receiver **31'.** More particularly, in this embodiment the frequency correction circuit **40'** includes a frequency comparator which compares a difference between the output frequencies of the VCTCXO **22'** and TXCO **26',** and a correction circuit which adjusts the TXCO output based upon the difference between the frequencies and the offset correction from the microprocessor **32',** as will be appreciated by those skilled in the art. An exemplary frequency comparator/correction circuit configuration which may be used for this purpose is provided in the above-noted U.S. Patent No. 6,741,842, for example.

It should also be noted that in the embodiment shown in FIG. 3 there is no cellular receiver **23,** only the satellite positioning receiver **31'.** That is, this embodiment is directed to a handheld satellite positioning device without cellular capabilities. Thus, in this embodiment, the timing signals that are used for generating the historical correction values and calibrating the VCTCXO **22'** are provided by the satellite positioning network. Thus, the VCTCXO **22'** need not necessarily provide a frequency used for a cellular reference clock (which may be about 16.8 MHz, for example), but instead could take other values as well. By way of example, a typical reference clock oscillator frequency for a GPS receiver may be about 24.5535 MHz, although other frequencies may be used in different embodiments.

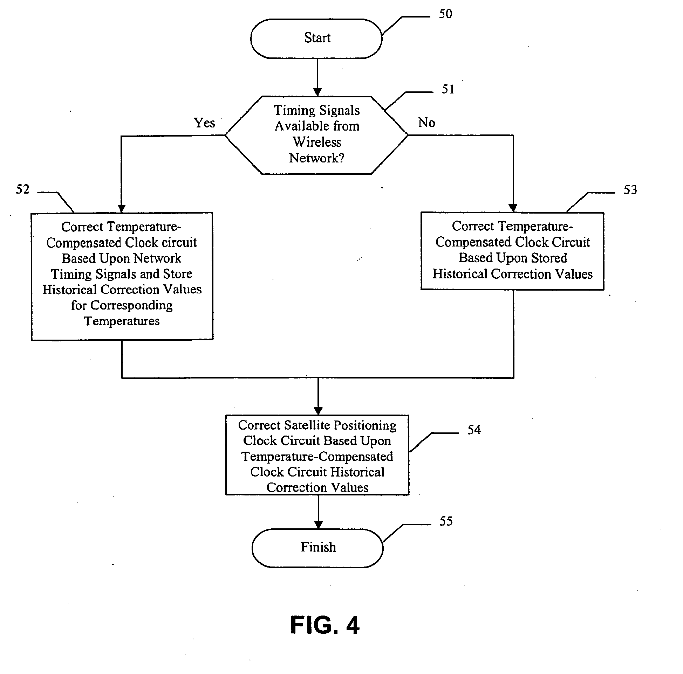

Turning now additionally to FIG. 4, a clock correction method for the wireless communications device **20** is now discussed. Beginning at Block **50,** when timing signals are available from the wireless network **25,** at Block **51,** the temperature-compensated clock circuit **22** is corrected based the timing signals, and historical correction values for corresponding temperatures are stored, at Block **52.** However, when timing signals are unavailable from the wireless network **25,** the temperature-compensated clock circuit **22** is corrected based upon the stored historical correction values, at Block **53,** as discussed further above. In either case, the satellite positioning clock circuit **26** is corrected based upon the corrected temperature-compensated clock circuit, at Block **54,** thus concluding the illustrated method. Of course, it will be appreciated that in actual operation the step illustrated at Block **51** would be repeated after the step illustrated at Block **54.**

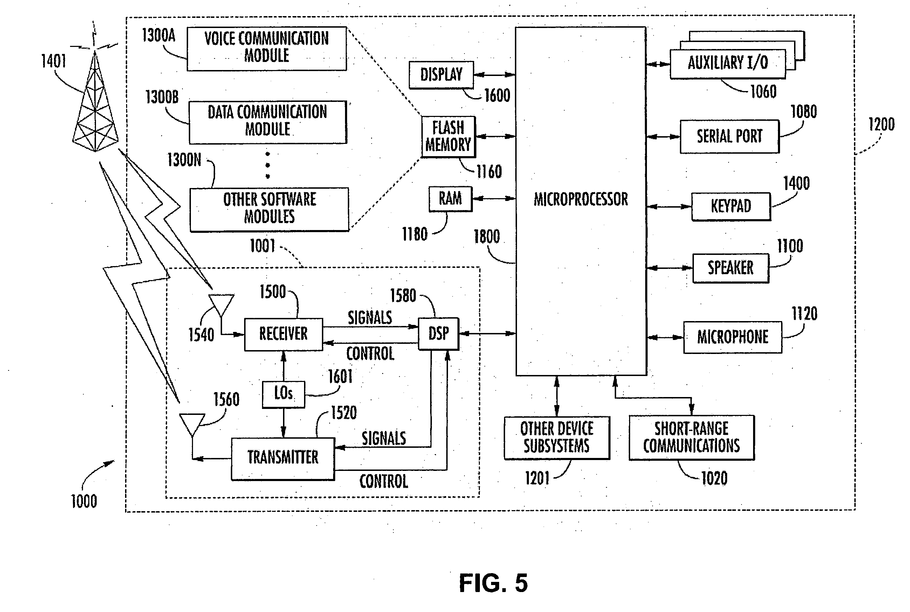

Other exemplary components that may be used in the device **20** are now further described with reference to a hand-held mobile wireless communications device **1000** as shown in FIG. 5. The device **1000** illustratively includes a housing **1200,** a keypad **1400** and an output device **1600.** The output device shown is a display **1600,** which is preferably a full graphic LCD. Other types of output devices may alternatively be utilized. A processing device **1800** is contained within the housing **1200** and is coupled between the keypad **1400** and the display **1600.** The processing device **1800** controls the operation of the display **1600,** as well as the overall operation of the mobile device **1000,** in response to actuation of keys on the keypad **1400** by the user.

The housing **1200** may be elongated vertically, or may take on other sizes and shapes (including clamshell housing structures). The keypad may include a mode selection key, or other hardware or software for switching between text entry and telephony entry.

In addition to the processing device **1800,** other parts of the mobile device **1000** are shown schematically in FIG. 5. These include a communications subsystem **1001;** a short-range communications subsystem **1020;** the keypad **1400** and the display **1600,** along with other input/output devices **1060, 1080, 1100** and **1120;** as well as memory devices **1160, 1180** and various other device subsystems **1201.** The mobile device **1000** is preferably a two-way RF communications device having voice and data communications capabilities. In addition, the mobile device **1000** preferably has the capability to communicate with other computer systems via the Internet.

Operating system software executed by the processing device **1800** is preferably stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM **1180.**

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM is preferably capable of organizing and managing data items, such as e-mail, calendar events, voice mails, appointments, and task items. The PIM application is also preferably capable of sending and receiving data items via a wireless network **1401.** Preferably, the PIM data items are seamlessly integrated, synchronized and updated via the wireless network **1401** with the device user's corresponding data items stored or associated with a host computer system.

Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex^{™}, Data TAC^{™} or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device **1000.** The mobile device **1000** may also be compliant with other communications standards such as 3GSM, 3GPP, UMTS, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore requires a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem **1001** and is input to the processing device **1800.** The received signal is then further processed by the processing device **1800** for an output to the display **1600,** or alternatively to some other auxiliary I/O device **1060.** A device user may also compose data items, such as e-mail messages, using the keypad **1400** and/or some other auxiliary I/O device **1060,** such as a touchpad, a rocker switch, a thumb-wheel, or some other type of input device. The composed data items may then be transmitted over the communications network **1401** via the communications subsystem **1001.**

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device **1000.** In addition, the display **1600** may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, or a Bluetooth^{™} communications module to provide for communication with similarly-enabled systems and devices.

Many modifications and other embodiments will come to the mind of one skilled in the art having the benefit of the teachings presented in the foregoing descriptions and the associated drawings. Therefore, it is understood that various modifications and embodiments are intended to be included within the scope of the appended claims.

## Claims

1. A wireless communications device (20') comprising:
a portable housing;
a temperature-compensated clock circuit (22') carried by said portable housing;
a wireless satellite positioning receiver (31') carried by said portable housing for receiving timing signals, when available, from a wireless satellite positioning network;
a satellite positioning clock circuit (26') carried by said portable housing; and
at least one clock correction circuit (40') carried by said portable housing for
correcting said temperature-compensated clock circuit (22') based upon timing signals from the wireless satellite positioning network when available, and storing historical correction values (36') for corresponding temperatures,
correcting said temperature-compensated clock circuit (22') based upon the stored historical correction values (36') when timing signals are unavailable from the wireless satellite positioning network, and
correcting said satellite positioning clock (26') based upon said temperature-compensated clock circuit (22').

2. The wireless communications device (20') of Claim 1 wherein said temperature-compensated clock circuit (22') comprises a voltage-controlled temperature-compensated clock circuit; and wherein the historical correction values (36') comprise voltage correction values for said voltage-controlled temperature-compensated clock circuit (22').

3. The wireless communications device (20') of Claim 1 further comprising a temperature sensor (34') carried by said portable housing and connected to said at least one clock correction circuit (40').

4. The wireless communications device (20') of Claim 1 wherein said at least one clock correction circuit (40') comprises a processor (32').

5. The wireless communications device (20') of Claim 1 wherein said satellite positioning clock circuit (26') comprises a temperature-compensated crystal oscillator (TCXO).

6. The wireless communications device (20') of Claim 1 further comprising an analog-to-digital converter (35') coupled between said temperature-compensated clock circuit (22') and said at least one clock correction circuit (40').

7. The wireless communications device (20') of Claim 1 further comprising a digital-to-analog converter, DAC (33') coupled between said at least one clock correction circuit (40') and said temperature-compensated clock circuit (22').

8. A clock correction method for a wireless communications device (20') comprising a portable housing, a temperature-compensated clock circuit (22') carried by the portable housing, a wireless satellite positioning receiver (31') carried by the portable housing for receiving timing signals, when available, from a wireless satellite positioning network, and a satellite positioning clock circuit (26') carried by the portable housing, the method comprising:
when timing signals are available from the wireless satellite positioning network, correcting the temperature-compensated clock circuit based upon the timing signals and storing historical correction values (36') for corresponding temperatures;
when timing signals are unavailable from the wireless satellite positioning network, correcting the temperature-compensated clock circuit (22') based upon the stored historical correction values (36'); and
correcting the satellite positioning clock circuit (26') based upon the temperature-compensated clock circuit (22').

9. The method of Claim 8 wherein correcting the temperature-compensated clock circuit (22') comprises correcting a voltage-controlled temperature-compensated clock circuit; and wherein storing the historical correction values (36') comprises storing voltage correction values for the voltage-controlled temperature-compensated clock circuit.

10. The method of Claim 8 further comprising providing a temperature sensor (34') carried by the portable housing adjacent the temperature-compensated clock circuit (22').

11. The method of Claim 8 wherein correcting the satellite positioning clock circuit (26') comprises correcting a temperature-compensated crystal oscillator (TCXO).

## Patentansprüche

1. Drahtlose Kommunikationsvorrichtung (20'), die aufweist:
ein tragbares Gehäuse;
einen Temperatur-kompensierten Taktgeber (22'), der in dem tragbaren Gehäuse aufgenommen ist;
einen drahtlosen Satelliten-Positionierungs-Empfänger (31'), der in dem tragbaren Gehäuse aufgenommen ist, zum Empfangen von Timing-Signalen, wenn verfügbar, von einem drahtlosen Satellitenpositionierungsnetzwerk;
einen Satellitenpositionierungs-Taktgeber (26'), der in dem tragbaren Gehäuse aufgenommen ist; und
zumindest eine Taktkorrekturschaltung (40'), die in dem tragbaren Gehäuse aufgenommen ist, zum
Korrigieren des Temperatur-kompensierten Taktgebers (22') basierend auf Timing-Signalen von dem drahtlosen Satellitenpositionierungsnetzwerk, wenn verfügbar, und Speichern von historischen Korrekturwerten (36') für entsprechende Temperaturen,
Korrigieren des Temperatur-kompensierten Taktgebers (22') basierend auf den gespeicherten historischen Korrekturwerten (36'), wenn keine Timing-Signale von dem drahtlosen Satellitenpositionierungsnetzwerk verfügbar sind, und
Korrigieren des Satellitenpositionierungs-Taktgebers (26') basierend auf dem Temperatur-kompensierten Taktgeber (22').

2. Drahtlose Kommunikationsvorrichtung (20') gemäß Anspruch 1, wobei der Temperatur-kompensierte Taktgeber (22') einen Spannungs-gesteuerten Temperatur-kompensierten Taktgeber aufweist; und wobei die historischen Korrekturwerte (36') Spannungskorrekturwerte für den Spannungs-gesteuerten Temperatur-kompensierten Taktgeber (22') aufweisen.

3. Drahtlose Kommunikationsvorrichtung (20') gemäß Anspruch 1, die weiter aufweist einen Temperatursensor (34'), der in dem tragbaren Gehäuse aufgenommen ist und mit der zumindest einen Taktkorrekturschaltung (40') verbunden ist.

4. Drahtlose Kommunikationsvorrichtung (20') gemäß Anspruch 1, wobei die zumindest eine Taktkorrekturschaltung (40') einen Prozessor (32') aufweist.

5. Drahtlose Kommunikationsvorrichtung (20') gemäß Anspruch 1, wobei der Satellitenpositionierungs-Taktgeber (26') einen Temperatur-kompensierten Kristalloszillator (TCXO - temperature-compensated crystal oscillator) aufweist.

6. Drahtlose Kommunikationsvorrichtung (20') gemäß Anspruch 1, die weiter aufweist einen Analog-Digital-Wandler (35'), der zwischen dem Temperatur-kompensierten Taktgeber (22') und der zumindest einen Taktkorrekturschaltung (40') verbunden ist.

7. Drahtlose Kommunikationsvorrichtung (20') gemäß Anspruch 1, die weiter aufweist einen Digital-Analog-Wandler DAC (digital-to-analog converter) (33'), der zwischen der zumindest einen Taktkorrekturschaltung (40') und dem Temperatur-kompensierten Taktgeber (22') verbunden ist.

8. Taktkorrekturverfahren für eine drahtlose Kommunikationsvorrichtung (20'), die aufweist ein tragbares Gehäuse, einen Temperatur-kompensierten Taktgeber (22'), der in dem tragbaren Gehäuse aufgenommen ist, einen drahtlosen Satelliten-Positionierungs-Empfänger (31'), der in dem tragbaren Gehäuse aufgenommen ist, zum Empfangen von Timing-Signalen, wenn verfügbar, von einem drahtlosen Satellitenpositionierungsnetzwerk, und einen Satellitenpositionierungs-Taktgeber (26'), der in dem tragbaren Gehäuse aufgenommen ist, wobei das Verfahren aufweist:
wenn Timing-Signale von dem drahtlosen Satellitenpositionierungsnetzwerk verfügbar sind, Korrigieren des Temperatur-kompensierten Taktgebers basierend auf den Timing-Signalen und Speichern von historischen Korrekturwerten (36') für entsprechende Temperaturen;
wenn keine Timing-Signale von dem drahtlosen Satellitenpositionierungsnetzwerk verfügbar sind, Korrigieren des Temperatur-kompensierten Taktgebers (22') basierend auf den gespeicherten historischen Korrekturwerten (36'); und Korrigieren des Satellitenpositionierungs-Taktgebers (26') basierend auf dem Temperatur-kompensierten Taktgeber (22').

9. Verfahren gemäß Anspruch 8, wobei ein Korrigieren des Temperatur-kompensierten Taktgebers (22') ein Korrigieren eines Spannungs-gesteuerten Temperatur-kompensierten Taktgebers aufweist; und wobei ein Speichern der historischen Korrekturwerte (36') ein Speichern von Spannungskorrekturwerten für den Spannungs-gesteuerten Temperatur-kompensierten Taktgeber aufweist.

10. Verfahren gemäß Anspruch 8, das weiter aufweist Vorsehen eines Temperatursensors (34'), der in dem tragbaren Gehäuse aufgenommen ist angrenzend an den Temperatur-kompensierten Taktgeber (22').

11. Verfahren gemäß Anspruch 8, wobei ein Korrigieren des Satellitenpositionierungs-Taktgebers (26') ein Korrigieren eines Temperatur-kompensierten Kristalloszillators (TCXO - temperature-compensated crystal oscillator) aufweist.

## Revendications

1. Dispositif de communication sans fil (20') comprenant :
un boîtier portatif ;
un circuit d'horloge à compensation thermique (22'), supporté par ledit boîtier portatif ;
un récepteur sans fil de localisation par satellite (31'), supporté par ledit boîtier portatif, destiné à recevoir des signaux de synchronisation, lorsqu'ils sont disponibles, d'un réseau sans fil de localisation par satellite ;
un circuit d'horloge de localisation par satellite (26'), supporté par ledit boîtier portatif ; et
au moins un circuit de correction d'horloge (40'), supporté par ledit boîtier portatif, afin de :
corriger ledit circuit d'horloge à compensation thermique (22') sur la base de signaux de synchronisation provenant du réseau sans fil de localisation par satellite lorsqu'ils sont disponibles, et sauvegarder des valeurs de correction historiques (36') pour des températures correspondantes ;
corriger ledit circuit d'horloge à compensation thermique (22') sur la base des valeurs de correction historiques (36') sauvegardées lorsque des signaux de synchronisation ne sont pas disponibles en provenance du réseau sans fil de localisation par satellite ; et
corriger ladite horloge de localisation par satellite (26') sur la base dudit circuit d'horloge à compensation thermique (22').

2. Dispositif de communication sans fil (20') selon la revendication 1, dans lequel ledit circuit d'horloge à compensation thermique (22') est constitué d'un circuit d'horloge à compensation thermique commandé en tension, et dans lequel les valeurs de correction historiques (36') sont constituées de valeur de correction de tension pour ledit circuit d'horloge à compensation thermique (22') commandé en tension.

3. Dispositif de communication sans fil (20') selon la revendication 1, comprenant en outre un capteur thermique (34') supporté par ledit boîtier portatif et connecté audit au moins un circuit de correction d'horloge (40').

4. Dispositif de communication sans fil (20') selon la revendication 1, dans lequel ledit au moins un circuit de correction d'horloge (40') comprend un processeur (32').

5. Dispositif de communication sans fil (20') selon la revendication 1, dans lequel ledit circuit d'horloge de localisation par satellite (26') comprend un oscillateur à quartz à compensation thermique (TCXO pour « *Temperature Compensated Crystal Oscillator* »).

6. Dispositif de communication sans fil (20') selon la revendication 1, comprenant en outre un convertisseur analogique-numérique (35') couplé entre ledit circuit d'horloge à compensation thermique (22') et ledit au moins un circuit de correction d'horloge (40').

7. Dispositif de communication sans fil (20') selon la revendication 1, comprenant en outre un convertisseur numérique-analogique (33') couplé entre ledit au moins un circuit de correction d'horloge (40') et ledit circuit d'horloge à compensation thermique (22').

8. Procédé de correction d'horloge pour un dispositif de communication sans fil (20') comprenant un boîtier portatif, un circuit d'horloge à compensation thermique (22') supporté par le boîtier portatif, un récepteur sans fil de localisation par satellite (31') supporté par le boîtier portatif et destiné à recevoir des signaux de synchronisation, lorsqu'ils sont disponibles, en provenance d'un réseau sans fil de localisation par satellite, et un circuit d'horloge de localisation par satellite (26') supporté par le boîtier portatif, le procédé comprenant les étapes consistant à :
lorsque des signaux de synchronisation sont disponibles en provenance du réseau sans fil de localisation par satellite, corriger le circuit d'horloge à compensation thermique sur la base des signaux de synchronisation et sauvegarder des valeurs de correction historiques (36') pour des températures correspondantes ;
lorsque des signaux de synchronisation ne sont pas disponibles en provenance du réseau sans fil de localisation par satellite, corriger le circuit d'horloge à compensation thermique (22') sur la base des valeurs de correction historiques (36') sauvegardées ; et
corriger le circuit d'horloge de localisation par satellite (26') sur la base du circuit d'horloge à compensation thermique (22').

9. Procédé selon la revendication 8, dans lequel la correction du circuit d'horloge à compensation thermique (22') comprend la correction d'un circuit d'horloge à compensation thermique commandé en tension, et dans lequel la sauvegarde des valeurs de correction historiques (36') comprend la sauvegarde de valeurs de correction de tension pour le circuit d'horloge à compensation thermique commandé en tension.

10. Procédé selon la revendication 8, comprenant en outre l'étape consistant à fournir un capteur thermique (34') supporté par le boîtier portatif, adjacent au circuit d'horloge à compensation thermique (22').

11. Procédé selon la revendication 8, dans lequel la correction du circuit d'horloge de localisation par satellite (26') comprend la correction d'un oscillateur à quartz à compensation thermique (TCXO).
